# EUROPÄISCHE PATENTSCHRIFT

(11) **EP 0 722 220 B1**
(45) Veröffentlichungstag und Bekanntmachung des Hinweises auf die Patenterteilung: **20.10.1999**
(21) Anmeldenummer: 96100125.2
(22) Anmeldetag: 05.01.1996
(51) Int. Cl.: H03K 5/26

(54) **Frequenzdetector unter Verwendung von mehreren Phasendetektoren**
Frequency detector using multiple phase detectors
Détecteur de fréquence utilisant des détecteurs de phase multiples

(30) Priorität: 11.01.1995 DE 19500625
(43) Veröffentlichungstag der Anmeldung: 17.07.1996
(73) Patentinhaber: SIEMENS AKTIENGESELLSCHAFT, 80333 München (DE)
(72) Erfinder: Dirk, Friedrich, Dipl.-Ing., D-81739 München (DE)

(56) Entgegenhaltungen:
- EP-A- 0 520 590
- GB-A- 2 091 961
- US-A- 4 773 085
- IEEE INTERNATIONAL SOLID STATE CIRCUITS CONFERENCE, 14.Februar 1990, NEW YORK US, Seiten 104-105,274, XP000201844 B. KIM ET. AL.: "A 30MHZ HIGH SPEED ANALOG/DIGITAL PLL IN 2micrometer CMOS"
- INTERNATIONAL JOURNAL OF ELECTRONICS, Bd. 56, Nr. 6, 1.Juni 1984, BASINGSTOKE ,GB, Seiten 847-854, XP002001862 J. NIEZNANSKI ET. AL.: "PLL FIRING ANGLE CONTROLLERS WITH MULTIPHASE PHASE DETECTORS"

## Beschreibung

Die Erfindung betrifft einen Rotationsfrequenzdetektor mit einem Drei-Phasen-Taktgenerator, der drei Taktsignale jeweils mit einer Phasenverschiebung von ±120° gegenüber den jeweils anderen Taktsignalen erzeugt, mit einer Verknüpfungseinrichtung, an die ein Eingangssignal sowie die drei Taktsignale angelegt sind und die drei jeweils aus der Verknüpfung des Eingangssignals mit jeweils einem der drei Taktsignale hervorgehende Steuersignale abgibt, und mit einer Auswertelogik, an die die drei Steuersignale angelegt sind und die mindestens ein die Richtung der Phasenverschiebung zwischen den drei Taktsignalen angebendes Ausgangssignal bereitstellt.

Ein derartiger Rotationsfrequenzdetektor ist beispielsweise aus Ansgar Pottbäcker, Integrierte Phasen-/Frequenzregelschleife zur Taktrückgewinnung für Datenraten bis lOGbit/s, Dissertation an der Ruhr-Universität Bochum, Bochum 1993, Seiten 52 bis 55 bekannt. Die Verknüpfungseinrichtung besteht dabei aus einem Nulldurchgangsdetektor, der die Nulldurchgänge des Eingangssignals ermittelt und ein dementsprechendes Ausgangssignal abgibt. Dieses Ausgangssignal wird jeweils einem Eingang dreier UND-Gatter zugeführt, deren anderer Eingang durch jeweils eines der drei Taktsignale des 3-Phasen-Taktgenerators angesteuert wird. An den Ausgängen der drei Gatter stehen die drei Steuersignale für die nachfolgende Auswertelogik bereit. Rotationsfrequenzdetektoren im allgemeinen haben die Eigenschaft, daß die Phase des Taktsignals in mindestens drei Teilintervalle unterteilt wird. Je nach Vorzeichen der Frequenzdifferenz zwischen Eingangs- und Taktsignal durchläuft die Phase diese Intervalle in einer unterschiedlichen Reihenfolge. Die Reihenfolge und damit das Vorzeichen der Frequenzdifferenz wird von dem Logikteil des Rotationsfrequenzdetektors ausgewertet. Der Rotationsfrequenzdetektor kann vollständig als digitale Schaltung entworfen werden und ist deshalb hervorragend zur Integration geeignet.

Je nach Vorzeichen der Frequenzdifferenz weisen die Impulse hinter den UND-Gattern eine unterschiedliche zeitliche Reihenfolge auf. Zur Detektion des Vorzeichens der Frequenzdifferenz wird die Reihenfolge der Ausgangsimpulse an den UND-Gattern ausgewertet, was mit Hilfe der Auswertelogik erfolgt.

Ein Nachteil der Schaltung besteht darin, daß der Rotationsfrequenzdetektor Signalimpulse mit einer Pulsdauer verarbeiten muß, die deutlich kleiner als die Periodendauer der Eingangssignale sind. Aus diesem Grund besitzt der Rotationsfrequenzdetektor eine deutlich niedrigere Arbeitsfrequenz als andere Detektoren.

Aus dem Stand der Technik IEEE International Solid State Circuits Conference, 1990, Seiten 104-10 und 274, ist eine Schaltung gemäß dem Oberbegriff des Patentanspruchs 1 bekannt.

Aufgabe der Erfindung ist es, einen Rotationsfrequenzdetektor mit höherer Arbeitsfrequenz anzugeben.

Die Aufgabe wird bei einem Rotationsfrequenzdetektor der eingangs genannten Art dadurch gelöst, daß die Verknüpfungseinrichtung drei Phasenvergleicher aufweist, die zum einen mit jeweils einem der drei Taktsignale und zum anderen mit dem Eingangssignal angesteuert werden und an deren Ausgängen jeweils eines der drei Steuersignale bereitsteht. Vorteilhaft ist, daß der erfindungsgemäße Rotationsfrequenzdetektor bis zu Frequenzen im Gigahertzbereich einsetzbar ist und dabei vollständig integrierbar ist.

Es sind Phasenvergleicher vorgesehen, bei denen das jeweilige Taktsignal mit dem Eingangssignal abgetastet wird. Derartige Phasenvergleicher haben vorteilhafterweise eine höhere Grenzfrequenz.

Bei der Erfindung ist weiterhin vorgesehen, daß die Phasenvergleicher jeweils zwei taktzustandsgesteuerte D-Flip-Flops enthalten, an deren Dateneingänge das jeweilige Taktsignal und an deren Takteingänge das Eingangssignal invertiert beziehungsweise nicht-invertiert angelegt ist und die jeweils einen Ausgang aufweisen, wobei die Ausgänge der beiden D-Flip-Flops mit den Eingängen eines durch das Eingangssignal getakteten und am Ausgang des jeweiligen Steuersignal führenden Multiplexer verbunden sind. Dieser Phasenvergleicher besitzt vorteilhafterweise eine sehr hohe Grenzfrequenz.

Die Erfindung wird nachfolgend anhand der in den Figuren der Zeichnung dargestellten Ausführungsbeispiele näher erläutert. Es zeigt:
- Figur 1: eine allgemeine Ausführungsform eines erfindungsgemäßen Rotationsfrequenzdetektors,
- Figur 2: eine bevorzugte erste Ausführungsform eines Phasenvergleichers zur Anwendung bei einem Phasendetektor nach Figur 1 und
- Figur 3: eine bevorzugte zweite Ausführungsform eines Phasenvergleichers zur Anwendung bei einem Rotationsfrequenzdetektor nach Figur 1.

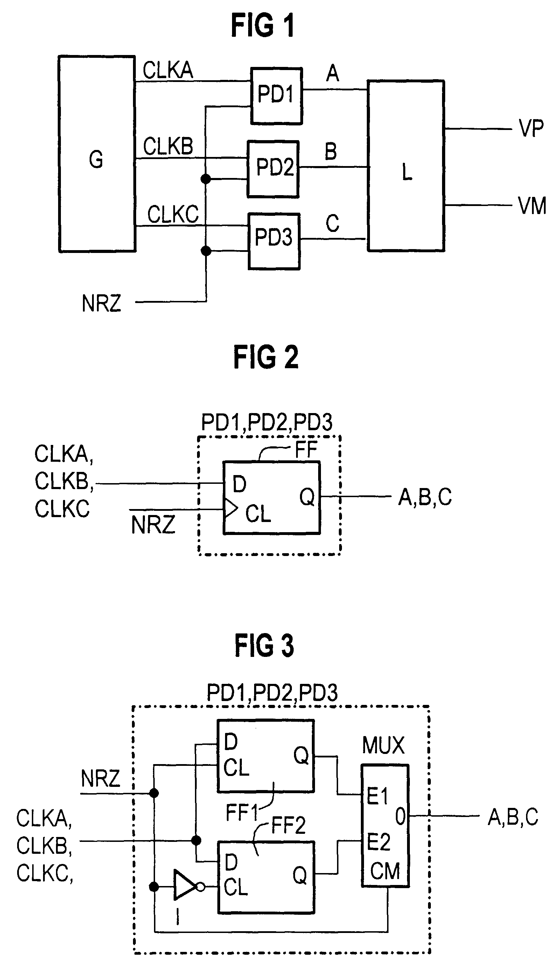

Bei der in Figur 1 gezeigten Ausführungsform besteht der erfindungsgemäße Rotationsfrequenzdetektor aus einem Drei-Phasen-Taktgenerator G, aus einer durch drei Phasenvergleicher PD1, PD2, PD3 gebildeten Verknüpfungseinrichtung sowie aus einer Auswertelogik L. Der Drei-Phasen-Taktgenerator G erzeugt drei Taktsignale CLKA, CLKB, CLKC mit jeweils einer Phasenverschiebung von ±120° gegenüber den jeweils anderen beiden Taktsignalen. Die Taktsignale CLKA, CLKB und CLKC sind an jeweils einen Eingang jeweils eines der drei Phasenvergleicher PD1, PD2 und PD3 angelegt, deren jeweils andere Eingänge mit einem Eingangssignal NRZ beaufschlagt sind. Aus dem Vergleich der jeweils an die Phasenvergleicher PD1 bis PD3 angelegten Eingangs- und Taktsignale gehen Steuersignale A, B, C hervor, die der Auswertelogik L zugeführt werden. Die Auswertelogik L erzeugt zwei Signale VM und VP, die angeben, in welcher Reihenfolge die Steuersignale A, B und C auftreten.

Je nach Vorzeichen der Frequenzdifferenz der an den Eingängen der Phasenvergleicher PD1, PD2, PD3 anliegenden Signale weisen die Impulse der Steuersignale A, B, C. eine unterschiedliche zeitliche Reihenfole auf. In dem Fall, daß die Frequenz des Drei-Phasen-Taktgenerators größer ist als die Frequenz des Eingangssignals entstehen Pulse in der Reihenfolge A-B-C und im umgekehrten Fall entstehen Pulse in der Reihensolge A-C-B. Zur Detektion des Vorzeichens der Frequenzdifferenz muß folglich die Reihenfolge der Ausgangsimpulse ausgewertet werden, was mit Hilfe der Auswertelogik L geschieht. Diese gibt bei Auftreten der Reihenfolge A-B-C ein Signal am Ausgang VP und bei Auftreten der Reihenfolge A-C-B ein Signal am Ausgang VM oder umgekehrt ab. Bei gleicher Frequenz wird kein Signal an beiden Ausgängen VP, VM erzeugt.

Die Phasenvergleicher PD1 bis PD3 weisen bevorzugt keine Differenzierer auf, da die Differenzierer zu einer Einschränkung der oberen Grenzfrequenz führen. Vielmehr sind Phasenvergleicher geeignet, bei denen ein ihnen jeweils zugeführtes Signal im Takt des anderen ihnen jeweils zugeführten Signals abgetastet wird.

Ein solcher Phasenvergleicher besteht gemäß Figur 2 beispielsweise aus einem D-Flip-Flop FF, an dessen flankengetriggerten Dateneingang D das jeweilige Taktsignal CLKA, CLKB, CLKC und an dessen Takteingang CL das Eingangssignal NRZ angelegt sind. Der Ausgang Q führt das jeweilige Steuersignal A, B, C.

Eine andere Ausführungsform enthält gemäß Figur 3 zwei taktzustandsgesteuerte D-Flip-Flops FF1 und FF2, deren Dateneingänge D mit dem jeweiligen Taktsignal CLKA, CLKB, CLKC beaufschlagt sind und an deren jeweiligen Takteingang CL das Eingangssignal NRZ zum einen direkt und zum anderen unter Zwischenschaltung eines Inverters I angelegt ist. Die Ausgänge Q der beiden D-Flip-Flops FF1 und FF2 sind auf die Eingänge E1 und E2 eines Multiplexers MUX geführt, dessen Auswahleingang CM durch das Eingangssignal NRZ angesteuert wird und dessen Ausgang O das jeweilige Steuersignal A, B, C führt. Bei differentieller Ausführung der beiden D-Flip-Flops FF1 und FF2 werden anstelle des Einsatzes von Invertern die entsprechenden invertierten und nicht-invertierten Signale an den nichtinvertierenden und invertierenden Eingang des D-Flip-Flops FF2 gelegt.

Eine bevorzugte Ausführungsform der Auswertelogik L ist der eingangs genannten Dissertation von Pottbäcker zu entnehmen.

## Patentansprüche

1. Rotationsfrequenzdetektor mit einem Drei-Phasen-Taktgenerator (G), der drei Taktsignale (CLKA, CLKB, CLKC) mit jeweils einer Phasenverschiebung von ±120° gegenüber den jeweils anderen Taktsignalen erzeugt, mit drei Phasenvergleichern (PD1, PD2, PD3), an die ein Eingangssignal (NRZ) sowie die drei Taktsignale (CLKA, CLKB, CLKC) angelegt sind und die drei jeweils aus der Verknüpfung des Eingangssignals (NRZ) mit jeweils einem der drei Taktsignale (CLKA, CLKB, CLKC) hervorgehende Steuersignale (A, B, C) abgeben, und mit einer Auswertelogik (L), an die die drei Steuersignale (A, B, C) angelegt sind und die mindestens ein die Richtung der Phasenverschiebung zwischen den drei Steuersignalen (A, B, C) angebendes Ausgangssignal (VP, VM) bereitstellt,
**dadurch gekennzeichnet,**
daß die Phasenvergleicher (PD1, PD2, PD3) jeweils zwei taktzustandsgesteuerte (Latch) D-Flip-Flops (FF1, FF2) enthalten, an deren Dateneingänge (D) das jeweilige Taktsignal (CLKA, CLKB, CLKC) und an deren Takteingänge (CL) das Eingangssignal (NRZ) invertiert beziehungsweise nicht-invertiert angelegt ist und die jeweils einen Ausgang (Q) aufweisen, wobei die Ausgänge (Q) der beiden D-Flip-Flops (FF1, FF2) mit den Eingängen (E1, E2) eines durch das Eingangssignal (NRZ) getakteten und am Ausgang (O) das jeweilige Steuersignal (A, B, C) führenden Multiplexers (MUX) verbunden sind.

## Claims

1. Rotation frequency detector having a three-phase clock generator (G), which produces three clock signals (CLKA, CLKB, CLKC) each having a phase shift of ±120° with respect to the other respective clock signals, having three phase comparators (PD1, PD2, PD3) to which an input signal (NRZ) as well as the three clock signals (CLKA, CLKB, CLKC) are applied, and which emit three control signals (A, B, C) respectively, which are obtained by linking the input signal (NRZ) to in each case one of the three clock signals (CLKA, CLKB, CLKC), and having an evaluation logic device (L), to which the three control signals (A, B, C) are applied and which produces at least one output signal (VP, VM) which indicates the direction of the phase shift between the three control signals (A, B, C),
characterized
in that the phase comparators (PD1, PD2, PD3) each contain two clock-state-controlled (latch) D flipflops (FF1, FF2), to whose data inputs (D) the respective clock signal (CLKA, CLKB, CLKC) is applied in inverted form, and to whose clock inputs (CL) the input signal (NRZ) is applied in the non-inverted form, and which each have one output (Q), wherein the outputs (Q) of the two D-flipflops (FF1, FF2) are connected to the inputs (E1, E2) of a multiplexer (MUX) which is clocked by the input signal (NRZ) and which carries the respective control signal (A, B, C) at the output (O).

## Revendications

1. Détecteur de fréquence utilisant des détecteurs de phases multiples, comprenant un générateur d'impulsions à trois phases (G) qui produit trois signaux de synchronisation (CLKA, CLKB, CLKC) présentant à chaque fois un déphasage de ± 120° par rapport à chacun des autres signaux de synchronisation, trois phasemètres (PD1, PD2, PD3) auxquels sont appliqués un signal d'entrée (NRZ) ainsi que les trois signaux de synchronisation (CLKA, CLKB, CLKC) et qui délivrent trois signaux de commande (A, B, C) résultant à chaque fois de l'enchaînement du signal d'entrée (NRZ) avec un signal respectif parmi les trois signaux de synchronisation (CLKA, CLKB, CLKC), et une logique d'analyse (L) à laquelle sont appliqués les trois signaux de commande (A, B, C) et qui fournit au moins un signal de sortie (VP, VM) indiquant le sens du déphasage entre les trois signaux de commande (A, B, C),
caractérisé en ce que
les phasemètres (PD1, PD2, PD3) contiennent à chaque fois deux bascules D (FF1, FF2) commandées par horloge ("latch") auxquelles sont appliqués, de manière inversée resp. non inversée, le signal de synchronisation respectif (CLKA, CLKB, CLKC) au niveau de leurs entrées des données (D) et le signal d'entrée (NRZ) au niveau de leurs entrées d'horloge (CL), et qui sont pourvues à chaque fois d'une sortie (Q), les sorties (Q) des deux bascules D (FF1, FF2) étant reliées aux entrées (E1, E2) d'un multiplexeur (MUX) synchronisé par le signal d'entrée (NRZ) et fournissant le signal de commande correspondant (A, B, C) à sa sortie (O).
